# EUROPÄISCHE PATENTSCHRIFT

(11) **EP 0 649 701 B1**
(45) Veröffentlichungstag und Bekanntmachung des Hinweises auf die Patenterteilung: **26.03.1997**
(21) Anmeldenummer: 94116171.3
(22) Anmeldetag: 13.10.1994
(51) Int. Cl.: B23K 20/00

(54) **Vorrichtung und Verfahren zum Drahtbonden**
Device and method of wire-bonding
Dispositif et procédé de connexion par fil

(30) Priorität: 18.10.1993 DE 4335468
(43) Veröffentlichungstag der Anmeldung: 26.04.1995
(73) Patentinhaber: F & K Delvotec Bondtechnik GmbH, D-82041 Oberhaching (DE)
(72) Erfinder: Farassat, Farhad, D-82024 Taufkirchen (DE)
(74) Vertreter: Popp, Eugen, Dr.

(56) Entgegenhaltungen:
- EP-A- 0 144 915
- EP-A- 0 203 597
- EP-A- 0 393 832
- WO-A-87/06864
- WO-A-88/05960
- US-A- 4 718 591

## Beschreibung

Die vorliegende Erfindung betrifft eine Vorrichtung zum Drahtbonden mit einem den Draht gegen eine Kontaktfläche pressenden, ultraschallerregbaren Stempel (wedge) sowie einem entsprechenden Bond-Verfahren.

Derartige Vorrichtungen und Verfahren sind heutzutage allgemein bekannt und werden in der Mikroelektronik zum Verbinden von Bauelementen untereinander durch Kleben oder Schweißen im Unterschied zum üblichen Löten, wo die Verbindungen mittels eines Lotes (meist Zinn-Blei-Legierung) hergestellt werden, eingesetzt. Dementsprechend sind eine Vielzahl von Vorrichtungen zum Drahtbonden mit einem den Draht gegen eine Kontaktfläche pressenden, ultraschallerregbaren Stempel (wedge) auf dem Markt erhältlich, der zu diesem Zweck an einem senkrecht zur Kontaktfläche auf- und abbewegbaren (z-Achse) Bondkopf angeordnet ist. Dabei befindet sich die Kontaktfläche auf einer in Richtung etwa quer zur Bewegungsrichtung (z-Achse) des Bondkopfes unter Positionierung der Kontaktfläche gegenüber dem Stempel bewegbaren Unterlage. Zusätzlich ist bei sämtlichen dieser Vorrichtungen eine Einrichtung zur Steuerung eines Antriebs für den Bondkopf vorgesehen. Nachteilig bei sämtlichen dieser Vorrichtungen ist deren Bauweise.

Herkömmlicherweise ist nämlich der Stempel am Bondkopf jeweils derart gelagert, daß der Stempel beim sogenannten "touch-down" ausschließlich eine Schwenkbewegung ausführt. Dies hat zur Folge, daß der Draht ungleichmäßig gegen die Kontaktfläche gepreßt wird. Dies wiederum stellt nach der Erfahrung eine hohe Gefahrenquelle für den vorzeitigen Bruch des sogenannten "bond-heel" dar. Zum anderen aber sind jeweils eine Vielzahl von Antrieben für den Bondkopf selbst, den Stempel, gegebenenfalls Klemmeinrichtungen zum Erfassen des Drahtes, das Messer zum Abtrennen des Drahtes etc. vorgesehen. Die Konstruktion ist dementsprechend aufwendig und großbauend. Insoweit sind die zu den bekannten Vorrichtungen gehörigen Verfahren aufgrund einer verhältnismäßig hohen Ausschußrate für die hergestellten mikroelektronischen Bauelemente und deren Komplexität noch verbesserbar.

Zum Ausgleich der beschriebenen Schwenkbewegung beim "touch-down" ist die in der US-PS 4 718 591 beschriebene Anordnung vorgesehen. Dort ist der Stempel an einem Rahmen des Bondkopfes beweglich gelagert. Wenn der Rahmen des Bondkopfes eine Schwenkbewegung ausführt, wird die Horizontalkomponente der Schwenkbewegung durch die bewegliche Lagerung des Stempels am Rahmen ausgeglichen. Im Ergebnis führt der Stempel dann nur eine Vertikalbewegung aus. Die Lagerung des Stempels am Rahmen ist jedoch äußerst aufwendig. Darüber hinaus muß das System vor dem Bonden stets exakt ausgerichtet werden, damit die Horizontalkomponente der Schwenkbewegung tatsächlich ausgeglichen wird. Ferner läßt sich die in Vertikalrichtung wirkende Kraft relativ schlecht einstellen. Ein herkömmliches Bondverfahren ist bereits aus der EP-A- 0 393 832 bekannt.

Der Erfindung liegt die Aufgabe zugrunde, eine Vorrichtung zum Drahtbonden nach dem Oberbegriff des Anspruchs 1 bereitzustellen, die hohe Maßgenauigkeiten und Funktionssicherheit der bearbeiteten Bauelemente gewährleistet und zudem einfach sowie kompakt aufgebaut ist. Zusätzlich liegt der Erfindung die Aufgabe zugrunde, ein diesbezüglich verbessertes Verfahren zum Drahtbonden vorzustellen.

Diese Aufgabe wird erfindungsgemäß durch die kennzeichnenden Merkmale des Anspruchs 1 in vorrichtungstechnischer Hinsicht und die Merkmale der Ansprüche 17 bzw. 18 in verfahrenstechnischer Hinsicht gelöst.

Durch die erfindungsgemäße Ausgestaltung der Vorrichtung, wonach der Stempel an einem Führungsschlitten befestigt ist, der parallel zur Bewegungsrichtung (Z-Achse) des Bondkopfes an diesem linear verschiebbar gelagert ist, ist einerseits eine wesentliche Verbesserung der Schweißqualität im Bereich der jeweiligen Bondstellen und andererseits eine einfache, zugleich sehr kompakte konstruktive Ausgestaltung gewährleistet. Durch die Linearführung des ultraschallerregbaren Stempels parallel zur Bewegungsrichtung (z-Achse) des Bondkopfes an diesem ist eine gleichmäßige Druckbeaufschlagung des Drahtes im Bereich der jeweiligen Kontaktfläche sichergestellt, da der Einfluß von Seitenkräften bedingt durch eine überlagerte Horizontalbewegungskomponente des Stempels ausgeschlossen ist. Infolgedessen ist eine gleichmäßige Bondstelle erreicht, wodurch einer Bruchgefahr des sogenannten" bond-heel" sicher entgegengewirkt ist. Zum anderen ist die Bauweise wesentlich vereinfacht und damit einhergehend die Bauhöhe verkleinert, da nicht zuletzt infolge der vorgesehenen Linearführung des ultraschallerregbaren Stempels nur ein einziger Antrieb erforderlich ist, der den gesamten Bondkopf in dessen Bewegungsrichtung (z-Achse) auf- und abwärts bewegt.

Dabei ist der Stempel an einem Führungsschlitten befestigt, der parallel zur Bewegungsrichtung (z-Achse) des Bondkopfes von diesem linear verschiebbar aufgenommen ist. Ein solcher Führungsschlitten hat den zusätzlichen Vorteil, daß gegebenenfalls außer dem Stempel weitere Bauelemente, wie z.B. ein ultraschallerzeugender Transducer etc., parallel zur Bewegungsrichtung (z-Achse) des Bondeskopfes linear verschiebbar gehalten sind.

Von besonderem Interesse für eine hohe Präzision des jeweiligen Bond ist der Führungsschlitten für den Stempel gemäß Anspruch 2, wonach der Stempel über eine Präzisionslinearführung (z. B. in Form eines Kugel-, Rollenlagers oder Luftpolsters) am Bondkopf verschiebbar gelagert ist.

Weiterhin liegt es im Rahmen der Erfindung nach Anspruch 3, daß der Bondkopf einen dem Stempel zugeordneten Sensor zur Bestimmung der sogenannten touch-down-Höhe umfaßt, der mit dem Antrieb für den Bondkopf gekoppelt ist. Mittels dieses Sensors ist beim "touch-down" die Ermittlung und Überwachung der nach oben gerichteten Bewegung von Stempel, ultraschallerzeugendem Transducer etc. relativ zum nach unten bewegten Bondkopf möglich. Bei Erreichen eines vorbestimmten programmierbaren Verschiebeweges liefert der Sensor ein Stop-Signal, woraufhin die Abwärtsbewegung des Bondkopfes und damit die Relativbewegung des Führungschlittens mit Stempel, Transducer etc. gestoppt wird.

In weiterer Ausgestaltung der Erfindung ist dem Stempel entsprechend den Merkmalen nach Anspruch 4 ein am Bondkopf starr fixiertes Messer zur insbesondere teilweisen Durchtrennung des Drahtes zugeordnet. Vorzugsweise kommt ein solches Messer bei Drähten größeren Durchmessers zum Einsatz, um ein Abreißen des zugeführten Drahtes nach dem Bonden zu erleichtern. Infolgedessen wird das Messer gemeinsam mit dem Bondkopf in dessen Bewegungsrichtung (z-Achse) an der zweiten Kontaktfläche nach dem "touch-down" in Richtung des Drahtes zu dessen, zumindest teilweisen, Durchtrennung automatisch weiterbewegt. Ein gesonderter Antrieb für das Messer ist, wie bei Vorrichtungen herkömmlicher Art, nicht erforderlich. Von zusätzlichem Vorteil in diesem Zusammenhang ist die Tatsache, daß der Antrieb für den Bondkopf in dessen Bewegungsrichtung (z-Achse) äußerst präzise, das heißt bis auf wenige Mikrometer genau, arbeitet, so daß gesonderte konstruktive Maßnahmen zum Erhalt genauer Schnittiefen des Messers, wie bei Vorrichtungen herkömmlicher Art, ebenfalls nicht notwendig sind.

Vorzugsweise ist für verschiedene Einsatzmöglichkeiten der erfindungsgemäßen Vorrichtung das Messer am Bondkopf entsprechend den Ansprüchen 5 und 6 einstellbar befestigt, und zwar zum einen in Bewegungsrichtung (z-Achse) des Bondkopfes und zum anderen in einer zur Bewegungsrichtung (z-Achse) des Bondkopfes senkrechten Richtung (x-Achse). Das letztgenannte Konstruktionsmerkmal erlaubt, daß das Messer in Zuführungsrichtung des Drahtes auf diesen alternativ vor oder hinter dem Stempel einwirkt. Der Bondkopf der erfindungsgemäßen Vorrichtung ist somit speziell auf verschiedenartigste Bedürfnisse oder Vorgaben, bedingt durch die Form, Anordnung usw. der elektrischen bzw. elektronischen Bauelemente, abstimmbar und daher ausgesprochen vielseitig einsetzbar. Auch ist der Bondkopf sowohl für Dickdraht- als auch Dünndrahtbonden geeignet. Die Messerschnittiefe ist in 5µ-Schritten programmierbar.

Weiterhin liegt es nach Anspruch 7 im Rahmen der Erfindung, dem Messer einen Sensor zur Einstellung des maximalen Messerhubes in Bewegungsrichtung (z-Achse) des Bondkopfes zuzuordnen, wodurch ein ungewolltes vollständiges Durchtrennen des Drahtes und/oder ein ungewolltes Eintauchen des Messers in das Substrat oder des elektrischen bzw. elektronischen Bauelements sicher verhindert wird.

Von vorteilhafter Ausgestaltung für eine besonders exakte Beaufschlagung des Drahtes durch den Stempel mit einem sogenannten "Bondgewicht" sind die konstruktiven Maßnahmen nach den Ansprüchen 8 und 9. Demnach ist zwischen dem Bondkopf und dem Führungsschlitten für den Stempel eine Einrichtung zur Einstellung und Veränderung des den Draht durch den Stempel beaufschlagenden "Gewichts" angeordnet, wobei die Gewichtseinstellungseinrichtung eine Magnetfeld-Erzeugungsanordnung, zum Beispiel einen Hubmagneten, umfaßt, die bzw. der einen Kraftfluß zwischen dem Bondkopf und dem Führungsschlitten für den Stempel herstellt, welcher einstellbar ist und parallel zur Bewegungsrichtung (z-Achse) des Bondkopfes wirksam ist.

Zur zusätzlichen Vereinfachung der Bauweise ist gemäß Anspruch 10 zwischen dem Bondkopf und dem Führungsschlitten für den Stempel eine Kraftaufbringungseinrichtung zur Aufbringung einer Kraft angeordnet, welche entgegen der Wirkung der Gewichteinstellungseinrichtung und parallel zur Bewegungsrichtung (z-Achse) des Bondkopfes wirkt. Auf diese Weise kann der Führungsschlitten zusammen mit dem Stempel, dem ultraschallerzeugenden Transducer etc. ohne großen konstruktiven Aufwand selbsttätig in seine relativ zum Bondkopf unsere Ausgangslage zurückversetzt werden. Nach den Ansprüchen 11 und 12 ist es vorteilhaft, zwischen dem Bondkopf und dem Führungsschlitten ein einstellbares Federelement, das als eine Schraubenfeder oder dergleichen ausgebildet sein kann, anzuordnen.

Um eine übermäßig große Relativbewegung zwischen dem Bondkopf einerseits und dem Führungsschlitten für den Stempel andererseits zu vermeiden, ist der Kraftaufbringungseinrichtung nach Anspruch 13 ein Mikroschalter oder dergleichen Wegbegrenzungs-Schaltelement zugeordnet.

Für eine exakte Zuführung des Bond-Drahtes hin zur Kontaktfläche des Stempels ist diesem nach Anspruch 14 ein Führungsröhrchen für den Draht zugeordnet, das am Führungsschlitten befestigt ist. Dieses Führungsröhrchen ist auch für herkömmliche Bondköpfe von Vorteil, so daß dieses auch unabhängig von den vorgenannten Merkmalen als Erfindung beansprucht wird. Im Führungsröhrchen kann eine einstellbare Kunststoffbremse angeordnet sein, durch die die Drahtspannung während der "loop"-Bildung konstant gehalten werden kann. Die Bremse wird z. B. durch einen quer in das Röhrchen hineinbewegbaren Kunststoffblock oder eine Kunststoffhülse oder dgl. gebildet.

Von besonderem Interesse für eine ganz gezielte Zuführung des Drahtes hin zum unteren freien Ende bzw. zur Kontaktfläche des Stempels ist dem Drahtführungsröhrchen nach Anspruch 15 eine kapillarenförmige Führungshülse zu- bzw. nachgeordnet, die insbesondere in Richtung zum Stempelende hin am Führungsröhrchen federelastisch angelenkt ist. Diese kapillarenförmige Führungshülse läßt sich daher von einem Messer, das gegebenenfalls zwischen dem Stempel und dem Führungsröhrchen angeordnet ist, während des zumindest teilweisen Durchtrennungsvorganges des Drahtes in eine Richtung bewegen, in der sie mit dem Führungsrohr nahezu fluchtet. Nach erfolgter Einwirkung des Messers auf den Draht und entsprechender Relativbewegung zwischen Bondkopf und Führungsschlitten schwenkt die kapillarenförmige Führungshülse, die am Ende des Führungsröhrchens angelenkt ist, selbsttätig wieder zurück in Richtung hin zum unteren Stempelende.

Um einen zusätzlichen Freiheitsgrad zu erhalten, der die Vielseitigkeit der erfindungsgemäßen Vorrichtung erhöht, ist der Bondkopf nach Anspruch 16 mit einem Drehrahmen zur Bewegung des Bondkopfes, des Stempels usw. in einer zu der Unterlage parallelen Ebene (x-Achse, y-Achse) versehen.

Die zuvor genannte Aufgabe wird in verfahrenstechnischer Hinsicht alternativ durch die Merkmale der Ansprüche 17 bzw. 18 gelöst.

Ein Ausführungsbeispiel des erfindungsgemüßen Verfahrens zum Drahtbonden umfaßt folgende Arbeitsschritte:

Zunächst wird der Bondkopf in Bondrichtung gedreht und ausgehend von dieser Startposition unter Mitnahme eines Drahtes hin zu einer ersten Kontaktfläche auf Bondhöhe abgesenkt. Sodann erfolgt ein sogenannter "touch-down" eines am Bondkopf angeordneten Stempels, und zwar unter Ultraschallerregung desselben. Hiermit einhergehend wird ein erster Bond ausgebildet. Anschließend wird der Bondkopf längs einer vorgegebenen Raumkurve unter Ausbildung eines sogenannten "loop" zu einer zweiten Kontaktfläche bewegt.

Es erfolgt ein erneuter "touch-down" des am Bondkopf angeordneten Stempels unter Ultraschallerzeugung desselben, so daß ein zweiter Bond ausgebildet wird. Danach wird der Bondkopf wieder etwas hoch und seitlich zurück, d. h. entgegen der Drahtzuführungsrichtung bewegt unter Ausbildung einer sogenannten "tail-length". Ist das Drahtmesser in Drahtzuführungsrichtung gesehen hinter dem Stempel angeordnet, erfolgt eine Zurückbewegung des Bondkopfes unter Ausbildung der sog. "tail-length" so weit, bis das Messer außerhalb der Bondstelle liegt. Dann wird der Bondkopf wieder abgesenkt, bis das Drahtmesser wirksam ist unter Ausbildung eines Trennschnitts, wobei der Draht nur teilweise durchtrennt wird. Danach fährt der Bondkopf wieder hoch und zurück, um den Draht an der Schnitt- bzw. Trennstelle abzureißen.

Wenn das Messer zwischen Stempel und Drahtführungsröhrchen liegt, wird die erste "tail-length"-Bewegung des Bondkopfes entbehrlich, wodurch sich die Arbeitsgeschwindigkeit erhöhen läßt. Mit der ersten Konstruktion, bei der das Messer hinter dem Stempel angeordnet ist, lassen sich jedoch besser bzw. präziser "loops" kleiner Abmessung herstellen; dann kann eine etwas geringere Arbeitsgeschwindigkeit in Kauf genommen werden.

Die beschriebenen Verfahrensweisen ermöglichen ein besonders präzises und wenig aufwendiges Drahtbonden. Zudem zeichnen sich diese Verfahrensweisen gegenüber dem Stand der Technik durch eine große Zeitersparnis für einen einzelnen Arbeitstakt aus. Mit der Erfindung läßt sich also eine erhöhte Taktfrequenz erreichen.

Die beschriebene Zurückbewegung des Bondkopfes läßt sich auch durch entsprechende Vorbewegung der Unterlage ersetzen. Insofern kommt es nur auf die Relativbewegung zwischen Bondkopf und Unterlage samt Kontaktflächen an.

Weitere Vorteile und Einzelheiten der Erfindung ergeben sich aus der nachfolgenden Beschreibung einer bevorzugten Ausführungsform der Erfindung sowie anhand der Zeichnung. Hierbei zeigen
- Fig. 1: eine Seitenansicht einer Ausführungsform einer erfindungsgemäß ausgebildeten Vorrichtung;
- Fig. 2: eine Draufsicht auf die Ausführungsform einer erfindungsgemäß ausgebildeten Vorrichtung nach Fig. 1 gemäß Pfeil II;
- Fig. 3: eine Vorderansicht auf die Ausführungsform einer erfindungsgemäß ausgebildeten Vorrichtung nach Fig. 1 gemäß Pfeil III; und
- Fig. 4 bis 10: den prinzipiellen Verfahrensablauf des erfindungsgemäßen Verfahrens zum Drahtbonden.

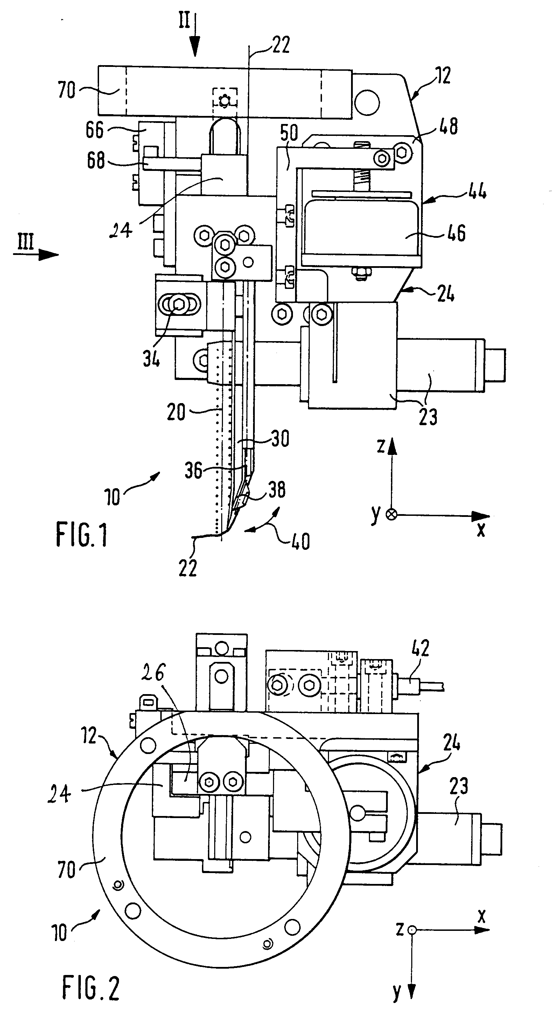

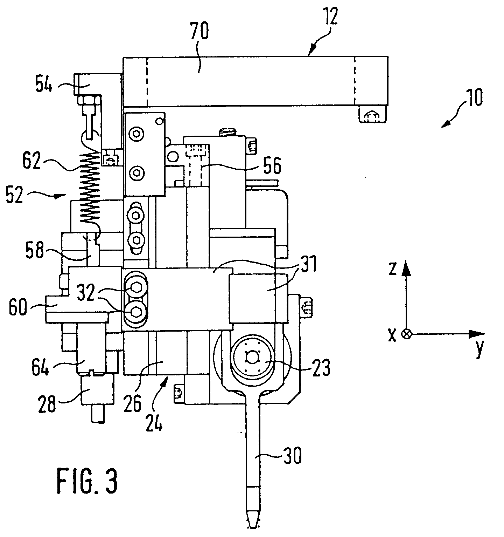

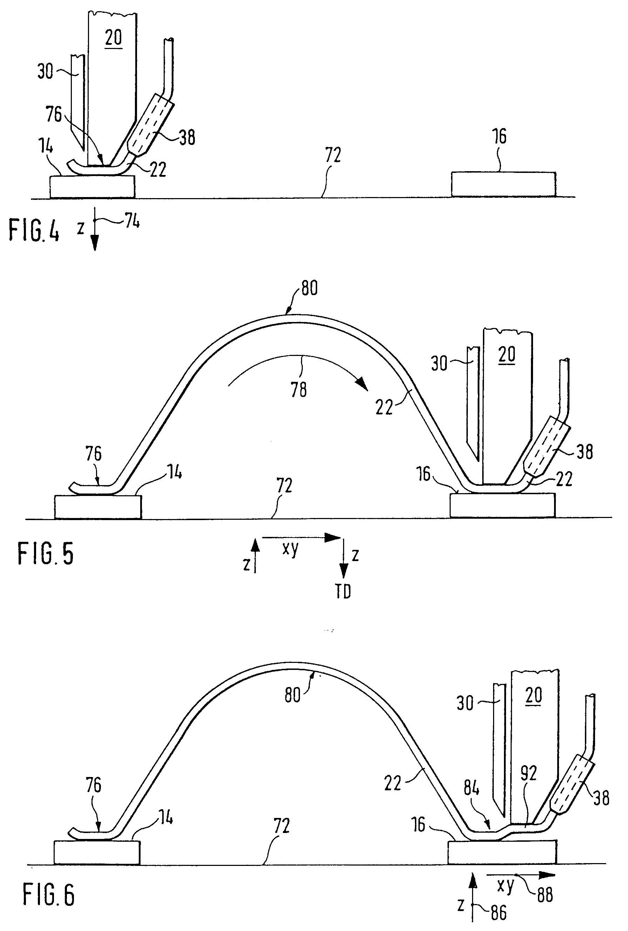

Die in den Fig. 1 bis 3 dargestellte Vorrichtung 10 zum Drahtbonden umfaßt einen Bondkopf 12, der über einen nicht dargestellten Antrieb senkrecht zu einer Kontaktfläche 14 bzw. 16 (vgl. Fig. 4 bis 10) entsprechend der z-Achse auf- und abbewegbar ist. Die Kontaktfläche 14 bzw. 16 befindet sich auf einer Unterlage 18 (vgl. Fig. 4 bis 10), die in Richtung etwa quer zur z-Achse des Bondkopfes 12 unter Positionierung der Kontaktfläche 14 bzw. 16 gegenüber dem Bondkopf 12 bewegbar ist. Zusätzlich umfaßt die erfindungsgemäße Vorrichtung 10 zum Drahtbonden eine Einrichtung zur Steuerung (ebenfalls nicht dargestellt) des Antriebs für den Bondkopf 12.

Der Bondkopf 12 umfaßt einen Stempel (wedge) 20, der einen Bond-Draht 22 gegen die Kontaktfläche 14 bzw. 16 preßt und über einen Transducer 23 ultraschallerregbar ist. Der Stempel 20 selbst ist parallel zur Bewegungsrichtung des Bondkopfes 12, d.h. in Richtung der z-Achse an diesem linear verschiebbar gelagert.

Zu diesem Zweck ist der Stempel 20 an einem Führungsschlitten 24 befestigt, der parallel zur Bewegungsrichtung des Bondkopfes 12, d.h. in Richtung der z-Achse von diesem linear verschiebbar aufgenommen ist. Der Führungsschlitten 24 für den Stempel 20 ist über eine Präzisionslinearführung 26 am Bondkopf verschiebbar gelagert. Hierdurch ist eine hohe Maßgenauigkeit und Bruchsicherheit beim Drahtbonden sichergestellt.

Weiterhin ist der Bondkopf 12 mit einem Sensor 28 zur Bestimmung bzw. Erfassung der sogenannten "touch-down"-Höhe versehen, der dem Stempel 20 zugeordnet ist. Der Sensor 28 ist mit dem Antrieb für den Bondkopf 12 über die Einrichtung zu dessen Steuerung gekoppelt.

Des weiteren ist am Bondkopf 12 ein Messer 30 befestigt, das dem Stempel 20 zur, insbesondere teilweisen, Durchtrennung des Drahtes 22 zugeordnet ist. Sofern der Bonddraht 22 ein Dünndraht aus Gold oder dergleichen ist, kann auf ein solches Messer 30 verzichtet werden. Das Messer 30 kommt also in erster Linie beim Dickdrahtbonden zum Einsatz.

Zum einen ist das Messer 30 am Bondkopf 12 in dessen Bewegungsrichtung bzw. in Richtung der z-Achse über einen Messerhalter 31 mittels Schrauben, hier Innensechskantschrauben 32, einstellbar befestigt. Zum anderen ist das Messer 30 am Bondkopf 12 aber auch in Richtung senkrecht zur z-Achse (x-Achse) einstellbar befestigt, und zwar hier mit einer Schraube, nämlich Innensechskantschraube 34. Auf diese Weise kann das Messer 30 in Bezug auf den Stempel 20 derart angeordnet werden, daß das Messer 30 auf den Draht 22 in Drahtzuführungsrichtung hinter oder - wie in den Figuren 1 bis 3 dargestellt - vor dem Stempel 20 einwirkt. Das in den Figuren 1 bis 3 gezeigte Messer 30 ist zwischen dem Stempel 20 einerseits und einem sich parallel zum Stempel 20 erstreckenden Drahtführungsröhrchen 36 (Kapillare) andererseits angeordnet.

Das Drahtführungsröhrchen 36 ist am Führungsschlitten 24 befestigt und dementsprechend mit dem Stempel 20 mitbewegbar. Wie aus Fig. 1 deutlich hervorgeht, ist am unteren freien Ende des Führungsröhrchens 36 eine Führungshülse 38 zur Ausrichtung des Drahtes 22 hin zum freien unteren Ende bzw. zur Kontaktfläche des Stempels 20 vorgesehen. Die Führungshülse 38 ist kapillarenförmig ausgebildet und im vorliegenden Fall federelastisch ans Führungsröhrchen angelenkt. Die Führungshülse 38 ist insofern gemäß Doppelpfeil 40 in Fig. 1 verschwenkbar am Führungsröhrchen 36 angebracht, so daß beim Trennschnitt des Drahtes die Führungshülse 38 aus der Bewegungsbahn des Messers 30 von diesem herausbewegbar ist bzw. sich nach Beendigung des Trennvorganges in die Bewegungsbahn des Messers unter federelastischer Abstützung an diesem wieder selbsttätig hineinbewegt.

Das Führungsröhrchen 36 selbst ist ebenso wie das Messer 30 am Bondkopf in Richtung senkrecht zur z-Achse, das heißt in Richtung der x-Achse mittels Schrauben einstellbar befestigt.

Darüber hinaus ist dem Messer 30 ein Sensor 42 zur Einstellung des maximalen Messerhubes in Bewegungsrichtung des Bondkopfes 12 zugeordnet. Mit dem Sensor 42 kann ein ungewolltes, gegebenenfalls vollständiges Durchtrennen des Drahtes 22 durch das Messer 30 bzw. auch ein ungewolltes Eintauchen des Messers 30 in das Substrat oder in elektrische bzw. elektronische Bauelemente zuverlässig vermieden werden.

Zwischen dem Bondkopf 12 und dem Führungsschlitten 24 ist weiterhin eine Einrichtung 44 zur Einstellung und Veränderung des sogenannten "Bondgewichts", d.h. des beim Bonden den Draht 22 durch den Stempel 20 beaufschlagenden "Gewichts" angeordnet. Die Gewichtseinstellungseinrichtung 44 umfaßt eine Magnetfeld-Erzeugungsanordnung 46, 48, 50, die einen Kraftfluß zwischen dem Bondkopf 12 und dem Führungsschlitten 24 herstellt, welcher einstellbar und etwa parallel zur Bewegungsrichtung des Bondkopfes 12 beziehungsweise zur z-Richtung wirksam ist. Zu diesem Zweck weist die erwähnte Anordnung einerseits einen mit dem Führungsschlitten 24 fest verbundenen Hubmagneten 46 und andererseits einen über einen Winkel 48 mit dem Bondkopf 12 fest verbundenen Anker 50 auf.

Zwischen dem Bondkopf 12 und dem Führungsschlitten 24 für den Stempel 20 ist eine Einrichtung 52 zur Aufbringung einer Kraft angeordnet, die entgegen der Wirkung der Gewichtseinstellungseinrichtung 44 in Richtung der z-Achse wirksam ist. Diese Kraftaufbringungseinrichtung 52 umfaßt zum einen ein Aufnahmeelement 54, das über einen Aufnahmewinkel 56 mit dem verschiebbar gelagerten Führungsschlitten 24 fest verbunden ist, und ein Halteelement 58, das über einen Lagerbock 60 oder dergleichen an Bondkopf 12 befestigt ist. Zwischen dem mit dem Bondkopf 12 verbundenen Haltelement 58 und dem an dem Führungsschlitten 24 angebrachten Aufnahmeelement 54 ist eine Zugfeder 62 angeordnet, deren Zugkraft über eine Einstellschraube 64, welche mit dem Halteelement 58 verbunden ist, einstellbar ist.

Die Kraftaufbringungseinrichtung 52 ist weiterhin mit einem Mikroschalter 66 versehen, der zur Begrenzung der Relativbewegung zwischen dem Bondkopf 12 und dem Führungsschlitten 24 für den Stempel 20 vorgesehen ist. Der Mikroschalter 66 ist entsprechend Fig. 1 von einem Zylinderstift 68 betätigbar, der über den Aufnahmewinkel 56 mit dem Führungsschlitten 24 fest verbunden ist.

Um den Bondkopf 12 an dessen nicht gezeigtem Antrieb in beliebiger Ausrichtung um dessen z-Achse in einer zu der Unterlage 18 parallelen Ebene, die von der x-Achse und der y-Achse aufgespannt ist, zu befestigen, ist der Bondkopf 12 zusätzlich mit einem Drehrahmen 70 ausgestattet. Im einzelnen nicht dargestellte Schrauben oder dergleichen Befestigungsmittel legen dabei den Drehrahmen 70 an dem Antrieb des Bondkopfes 12 fest.

Nachfolgend wird auf schematische Weise ein bevorzugtes Ausführungsbeispiel des Verfahrens zum Drahtbonden nach der Erfindung anhand der Fig. 4 bis 9 näher erläutert. Der in den Fig. 4 bis 9 gezeigte Verfahrensablauf erfolgt dabei unter Verwendung einer Vorrichtung, bei der das Drahtmesser 30 in Drahtzuführungsrichtung hinter dem Stempel 20 am Bondkopf 12 angebracht ist.

Gemäß Fig. 4 ist der Bondkopf 12 bzw. der relativ zu diesem verschiebbare Stempel 20 auf eine erste Kontaktfläche 14 auf einem Bauelement 72, welches sich auf einer nicht näher dargestellten Unterlage befindet, gemäß Pfeil 74 abgesenkt. Dabei wird der Draht 22 auf im einzelnen nicht dargestellte Weise von dem Bondkopf 12 mitgenommen bzw. bei hinreichend hoher Steifigkeit durch das Drahtführungsröhrchen 36 nachgeschoben.

Die Fig. 4 zeigt den sogenannten "touch-down" des am Bondkopf 12 angeordneten und ultraschall-erregten Stempels 20 unter Ausbildung eines ersten Bonds 76. Der Stempel 20 ragt zu diesem Zweck über das Messer 30 und das Führungsröhrchen bzw. die Führungshülse 38 hinaus, so daß das Messer 30 auf den Draht 22 noch nicht einwirkt.

Gemäß Fig. 5 wird der Bondkopf 12 sodann längs einer vorprogrammierten Raumkurve unter Ausbildung eines sogenannten "loop" 80 entsprechend Pfeil 78 zu einer zweiten Kontaktfläche 16 bewegt. Dort erfolgt ein erneuter "touch-down" unter Ausbildung eines zweiten Bonds 84. Wiederum steht der Stempel 20 über das freie Ende des Messers 30 und das freie Ende der Führungshülse 38 vor.

Gemäß Fig. 6 wird der Bondkopf sodann gemäß Pfeil 86 etwas hoch und gemäß Pfeil 88 zurückgefahren unter Ausbildung einer sogenannten "tail-length" 92. Das Messer 30 befindet sich dann in einer Position außerhalb des zweiten Bonds 84.

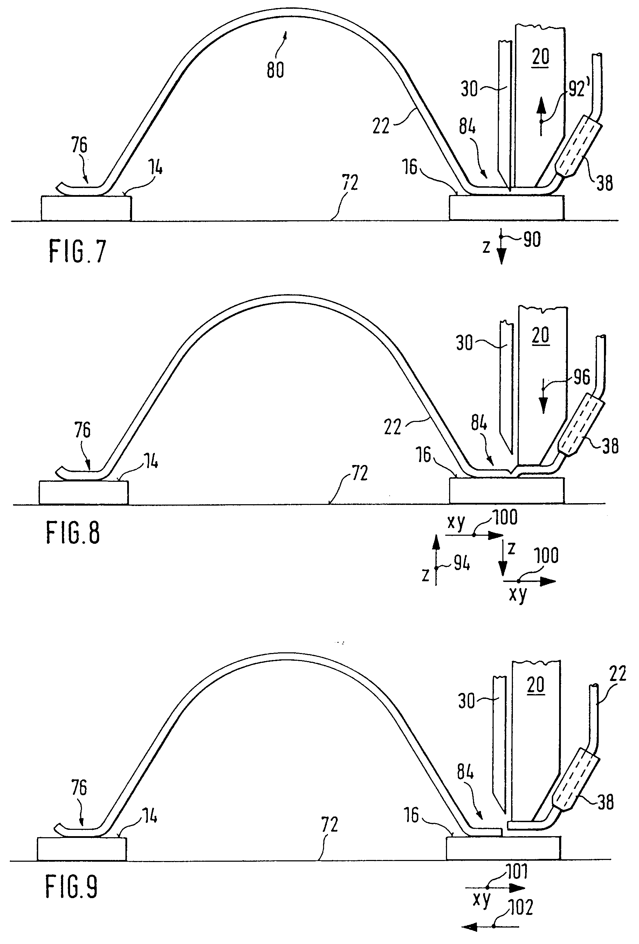

Gemäß Fig. 7 wird dann der Bondkopf 12 entsprechend Pfeil 90 wieder abgesenkt. Gleichzeitig erfolgt eine lineare, nach oben entsprechend Pfeil 92' gerichtete Verschiebung des Stempels 20 relativ zum Bondkopf 12. Auf diese Weise steht nunmehr das Messer 30 mit seiner Schneide sowohl über die untere Kontaktfläche des Stempels 20 als auch das untere Ende der Führungshülse 38 hinaus vor. Das am Bondkopf 12 angeordnete Messer 30 kann daher auf den Draht 22 einwirken und diesen zumindest teilweise durchtrennen.

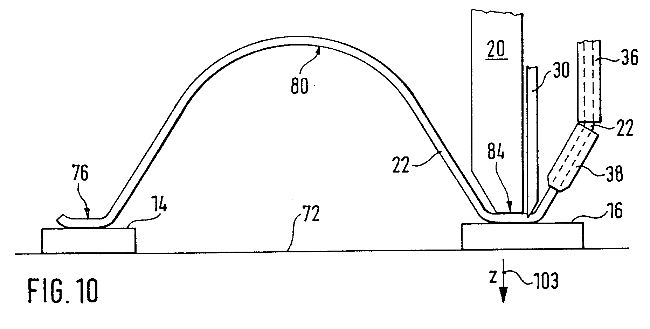

Gemäß Fig. 8 wird der Bondkopf 12 sodann entsprechend Pfeil 94 wieder hochgefahren, wobei das Messer 30 freikommt und der Stempel 20 zusammen mit dem Führungsschlitten 24 relativ zu dem Bondkopf 12 wieder linear nach unten entsprechend Pfeil 96 verschoben wird. Dann erfolgt eine seitliche Bewegung des Bondkopfes in Richtung des Pfeiles 100. Diese seitliche Bewegung wird gemäß Fig. 9 entsprechend Pfeil 101 fortgesetzt. Statt dessen kann auch die Unterlage entsprechend Pfeil 102 bewegt werden. Diese seitlichen Bewegungen haben ein Abreißen des Drahtes 22 zur Folge (Fig. 9).

Danach fährt der Bondkopf 12 wieder in seine Start- bzw. Ausgangsposition zurück, um mit einem neuen Arbeitstakt zu beginnen.

Sofern größere "loop"-Bildungen bei höherer Arbeitsgeschwindigkeit erwünscht sind, ist das Messer 30 in Drahtzuführungsrichtung gesehen vor dem Stempel 20, d.h. zwischen dem Stempel 20 und dem Draht-Führungsröhrchen 36 entsprechend den Figuren 1 bis 3 angeordnet. In diesem Falle kann auf die Arbeitsschritte, wie anhand der Fig. 6 erläutert, verzichtet werden. Einhergehend damit reduziert sich natürlich die Zeitdauer eines Arbeitstaktes entsprechend. Der Trennschnitt (Absenkung 103 des Bondkopfes) des Drahtes erfolgt dann entsprechend Fig. 10 unmittelbar nach dem zweiten "touch-down" auf der zweiten Kontaktfläche 16.

## Patentansprüche

1. Vorrichtung zum Drahtbonden mit einem den Draht (22) gegen eine Kontaktfläche (14, 16) pressenden, ultraschallerregbaren Stempel (wedge 20), der zu diesem Zweck an einem senkrecht zur Kontaktfläche (14, 16) auf- und abbewegbaren (z-Achse) Bondkopf (12) angeordnet ist, wobei sich die Kontaktfläche (14, 16) auf einer in Richtung etwa quer zur Bewegungsrichtung (z-Achse) des Bondkopfes (12) unter Positionierung der Kontaktfläche (14, 16) gegenüber dem Stempel (20) bewegbaren Unterlage (18) befindet, und einer Einrichtung zur Steuerung eines Antriebs für den Bondkopf (12), wobei der Stempel (20) am Bondkopf (12) beweglich gelagert ist,
**dadurch gekennzeichnet,**
daß der Stempel (20) an einem Führungsschlitten (24) befestigt ist, der parallel zur Bewegungsrichtung (z-Achse) des Bondkopfes (12) an diesem linear verschiebbar gelagert ist.

2. Vorrichtung nach Anspruch 1,
**dadurch gekennzeichnet,**
daß der Führungsschlitten (24) über eine Präzisionslinearführung (26), insbesondere kugel-, rollen- oder luftgelagerte Linearführung verschiebbar gehalten ist.

3. Vorrichtung nach einem der Ansprüche 1 oder 2,
**dadurch gekennzeichnet,**
daß der Bondkopf (12) einen dem Stempel (20) zugeordneten Sensor (28) zur Bestimmung der sogenannten touch-down-Höhe umfaßt, der mit dem Antrieb für den Bondkopf (12) gekoppelt ist.

4. Vorrichtung nach einem der Ansprüche 1 bis 3,
**dadurch gekennzeichnet,**
daß dem Stempel (20) ein Messer (30) oder dergleichen Trennelement zur, insbesondere teilweisen, Durchtrennung des Drahtes (22) zugeordnet ist, wobei das Messer (30) am Bondkopf (12) fest angeordnet, d.h. mit diesem mitbewegbar ist.

5. Vorrichtung nach Anspruch 4
**dadurch gekennzeichnet,**
daß das Messer (30) am Bondkopf (12) in dessen Bewegungsrichtung (z-Achse) einstellbar befestigt ist.

6. Vorrichtung nach Anspruch 4 und/oder 5,
**dadurch gekennzeichnet,**
daß das Messer (30) am Bondkopf (12) in einer zu dessen Bewegungsrichtung (z-Achse) senkrechten Richtung (x-Achse) einstellbar befestigt ist, insbesondere derart, daß das Messer (30) in Drahtzuführungsrichtung gesehen in eine Position entweder vor oder hinter dem Stempel (20) bringbar ist.

7. Vorrichtung nach einem der Ansprüche 4 bis 6,
**dadurch gekennzeichnet,**
daß dem Messer (30) ein Sensor (42) zur Einstellung des maximalen Messerhubes zugeordnet ist.

8. Vorrichtung nach einem der Ansprüche 1 bis 7,
**dadurch gekennzeichnet,**
daß zwischen dem Bondkopf (12) und dem Führungsschlitten (24) für den Stempel (20) eine Einrichtung (44) zur Einstellung des den Draht (22) beaufschlagenden "Gewichts" angeordnet ist.

9. Vorrichtung nach Anspruch 8,
**dadurch gekennzeichnet,**
daß die Gewichtseinstellungseinrichtung (44) eine Magnetfeld-Erzeugungsanordnung (46, 48, 50) umfaßt, mit der ein etwa parallel zur Bewegungsrichtung (z-Achse) des Bondkopfes (12) verlaufender Kraftfluß zwischen Bondkopf (12) und Führungsschlitten (24) einstellbar ist.

10. Vorrichtung nach Anspruch 8 und/oder 9,
**dadurch gekennzeichnet,**
daß zwischen dem Bondkopf (12) und dem Führungsschlitten (24) eine Kraftaufbringungseinrichtung (52) zur Aufbringung einer Kraft vorgesehen ist, die entgegen der Kraft der Gewichtseinstellungseinrichtung (44) und parallel zur Bewegungsrichtung (z-Achse) des Bondkopfes (12) wirkt.

11. Vorrichtung nach Anspruch 10,
**dadurch gekennzeichnet,**
daß zwischen dem Bondkopf (12) und dem Führungsschlitten (24) ein einstellbares Federelement (62) angeordnet ist.

12. Vorrichtung nach Anspruch 11,
**dadurch gekennzeichnet,**
daß als Federelement (62) eine Schraubenzugfeder vorgesehen ist.

13. Vorrichtung nach einem der Ansprüche 10 bis 12,
**dadurch gekennzeichnet,**
daß der Kraftaufbringungseinrichtung (52) ein Mikroschalter (66) zur Begrenzung der Relativbewegung zwischen Bondkopf (12) und Führungsschlitten (24) zugeordnet ist.

14. Vorrichtung nach einem der Ansprüche 1 bis 13,
**dadurch gekennzeichnet,**
daß dem Stempel (20) ein Führungsröhrchen (36) für den Draht (22) zugeordnet ist, das am Führungsschlitten (24) befestigt ist.

15. Vorrichtung nach Anspruch 14,
**dadurch gekennzeichnet,**
daß dem Führungsröhrchen (36) eine kapillarenförmige, insbesondere am Führungsröhrchen (36) federelastisch angelenkte Führungshülse (38) zur Ausrichtung des Drahtes (22) hin zum freien unteren Ende des Stempels (20) zugeordnet ist.

16. Vorrichtung nach einem der Ansprüche 1 bis 15,
**dadurch gekennzeichnet,**
daß der Bondkopf (12) einen Drehrahmen (70) zur Bewegung des Bondkopfes (12) und damit des Stempels (20) etc. in einer zu der Unterlage parallelen Ebene (x-Achse, y-Achse) aufweist.

17. Verfahren zum Drahtbonden, insbesondere mit einer Vorrichtung nach den Ansprüchen 1 bis 16, wobei das Messer (30) oder dergleichen Drahttrennelement in Drahtzuführungsrichtung gesehen vor dem Stempel (20) liegt, welches folgende Arbeitsschritte umfaßt:
a) Absenken des Bondkopfes (12) von einer oberen Start- bzw. Ausgangsposition unter Mitnahme eines Drahtes (22) hin zu einer ersten Kontaktfläche (14) auf Bondhöhe,
b) "touch-down" des am Bondkopf (12) angeordneten Stempels (20) unter Ultraschallerregung desselben und Ausbildung eines ersten Bonds (76) (Fig. 4),
c) Bewegen des Bondkopfes (12) längs einer vorgegebenen Raumkurve (78) unter Ausbildung eines Drahtloop (80) zu einer zweiten Kontaktfläche (16) (Fig. 5),
d) "touch-down" des am Bondkopf (12) angeordneten Stempels (20) unter Ultraschallerzeugung desselben und Ausbildung eines zweiten Bonds (84) (Fig. 5),
e) weiteres Absenken (103) des Bondkopfes (12) unter linearer, nach oben gerichteter (z-Achse) Verschiebung des Stempels (20) relativ zum Bondkopf (12) und unter teilweiser Durchtrennung des Drahtes (22) durch das am Bondkopf (12) angeordnete Messer (30) (Fig. 10),
f) Hochfahren (97) des Bondkopfes (12) unter Freigabe des Messers (30) und unter linearer nach unten gerichteter Verschiebung des Stempels (20) relativ zum Bondkopf (12) und seitliche Zurückbewegung (100, 101) des Bondkopfes (12) und/oder seitliche Vorbewegung (102) der Unterlage unter Abreißen des Drahtes (22) (Fig. 9), und
g) Hochfahren des Bondkopfes (12) in die Start- bzw. Ausgangsposition zurück.

18. Verfahren zum Drahtbonden, insbesondere mit einer Vorrichtung nach den Ansprüchen 1 bis 16, wobei das Messer (30) oder dergleichen Drahttrennelement in Drahtzuführungsrichtung gesehen hinter dem Stempel (20) liegt, welches folgende Arbeitsweise umfaßt:
a) Absenken des Bondkopfes (12) von einer oberen Start- bzw. Ausgangsposition unter Mitnahme eines Drahtes (22) hin zu einer ersten Kontaktfläche (14) auf Bondhöhe,
b) "touch-down" des am Bondkopf (12) angeordneten Stempels (20) unter Ultraschallerregung desselben und Ausbildung eines ersten Bonds (76) (Fig. 4),
c) Bewegen des Bondkopfes (12) längs einer vorgegebenen Raumkurve (78) unter Ausbildung eines Draht-loop (80) zu einer zweiten Kontaktfläche (16) (Fig. 5),
d) "touch-down" des am Bondkopf (12) angeordneten Stempels (20) unter Ultraschallerzeugung desselben und Ausbildung eines zweiten Bonds (84) (Fig. 5),
e) Hochfahren (86) und seitliche Zurückbewegung (88) des Bondkopfes (12) und/oder seitliche Vorbewegung der Unterlage unter Ausbildung eines sog. "tail-length" (92) (Fig. 6),
f) erneutes Absenken (90) des Bondkopfes (12) auf Draht (22) unter linearer, nach oben gerichteter (z-Achse) Verschiebung (92) des Stempels (20) relativ zum Bondkopf (12) und unter teilweiser Durchtrennung des Drahtes (22) durch das am Bondkopf (12) angeordnete Messer (30) (Fig. 7),
g) Hochfahren (94) des Bondkopfes (12) bis zu einer Draht-Abrißhöhe unter Freigabe des Messers (30) und unter linearer nach unten gerichteter Verschiebung (96) des Stempels (20) relativ zum Bondkopf (12) sowie seitliche Zurückbewegung (100, 101) des Bondkopfes (12) und/oder seitliche Vorbewegung (102) der Unterlage unter Abreißen des Drahtes (22) (Fig. 9), und
h) Hochfahren des Bondkopfes (12) in die Start- bzw. Ausgangsposition zurück.

## Claims

1. Device for bonding wire with a die (wedge 20), which may be energised by ultrasound and presses the wire (22) against a contact surface (14, 16), said die being for this purpose disposed on a bonding head (12) which is movable upwards and downwards (z-axis) vertically to the contact surface (14, 16), the contact surface (14, 16) being located on a support surface (18) movable in a direction approximately transversely to the direction of movement (z-axis) of the bonding head (12), positioning the contact surface (14, 16) relative to the die (20), and with a device for controlling the drive for the bonding head (12), the die (20) being movably mounted on the bonding head (12),
characterised in that
the die (20) is secured on a guide block (24) which is mounted on the bonding head (12) to be movable parallel to the direction of movement (z-axis) of the said bonding head (12).

2. Device according to claim 1,
characterised in that
the guide block (24) is movably secured via a precision linear guide means (26), particularly a linear guide which is mounted on ball, roller or air bearings.

3. Device according to one of claims 1 or 2,
characterised in that
the bonding head (12) includes a sensor (28) associated with the die (20) for determining the so-called touch-down height, and which is coupled to the drive system for the bonding head (12).

4. Device according to one of claims 1 to 3,
characterised in that
there is associated with the die (20) a cutter (30) or the like separating member for in particular partly separating the wire (22), the cutter (30) being rigidly mounted on the bonding head (12), i.e.being movable along with it.

5. Device according to claim 4,
characterised in that
the cutter (30) is secured on the bonding head (12) so as to be adjustable in its direction of movement (z-axis).

6. Device according to claim 4 and/or 5,
characterised in that
the cutter (30) is secured to the bonding head (12) so as to be adjustable in a direction (x-axis) vertical to its direction of movement (z-axis), particularly in such a way that the cutter (30), seen in the feed direction of the wire, can be brought into a position either before or behind the die (20).

7. Device according to one of claims 4 to 6,
characterised in that
there is associated with the cutter (30) a sensor (42) for setting the maximum stroke of the cutter.

8. Device according to one of claims 1 to 7,
characterised in that
an apparatus (44) for setting the weight acting upon the wire (22) is disposed between the bonding head (12) and the guide block (24) for the die (20).

9. Device according to claim 8,
characterised in that
the weight-setting apparatus (44) includes a device for generating a magnetic field (46, 48, 50), by means of which a power flux extending approximately parallel to the direction of movement (z-axis) of the bonding head (12) may be set between bonding head (12) and guide block (24).

10. Device according to claim 8 and/or 9,
characterised in that
there is provided between the bonding head (12) and the guide block (24) a force-applying apparatus (52) for application of a force which acts against the force of the weight-setting apparatus (44) and parallel to the direction of movement (z-axis) of the bonding head (12).

11. Device according to claim 10,
characterised in that
an adjustable resilient member (62) is disposed between the bonding head (12) and the guide block (24).

12. Device according to claim 11,
characterised in that
a helical tension spring is provided as a resilient member (62).

13. Device according to one of claims 10 to 12,
characterised in that
there is associated with the force-applying apparatus (52) a microswitch (66) for restricting the relative movement between bonding head (12) and guide block (24).

14. Device according to one of claims 1 to 13,
characterised in that
there is associated with the die (20) a guide tubelet (36) for the wire (22), which tubelet is secured on the guide block (24).

15. Device according to claim 14,
characterised in that
there is associated with the guide tubelet (36) a capillary-shaped guide sleeve (38), particularly resiliently articulated to the guide tubelet (36), for alignment of the wire (22) towards the free end of the die (20).

16. Device according to one of claims 1 to 15,
characterised in that
the bonding head (12) has a rotary frame (70) for moving the bonding head (12) and thus the die (20) etc. in a plane parallel to the support surface (x-axis, y-axis).

17. Method of bonding wire, particularly with a device according to claims 1 to 16, wherein the cutter (30) or the like wire-separating member, seen in the wire feed direction, lies in front of the die (20), and including the following working steps:
a) lowering the bonding head (12) from an upper start or outset position, carrying along with it a wire (22), to a first contact surface (14) at bonding height,
b) touch-down of the die (20) disposed on the bonding head (12), with ultrasound energisation of said die and formation of a first bond (76) (Fig. 4),
c) moving the bonding head (12) along a predetermined three-dimensional curve (78), forming a wire loop (80), to a second contact surface (16) (Fig. 5),
d) touch-down of the die (20) disposed on the bonding head (12), with ultrasound energisation of said die and formation of a second bond (84) (Fig. 5),
e) further lowering 103) of the bonding head (12) with linear, upwardly-oriented displacement (z-axis) of the die (20) relative to the bonding head (12), and with partial separation of the wire (22) by the cutter (30) disposed on the bonding head (12) (Fig. 10),
f) raising (97) the bonding head (12), releasing the cutter (30), and with linear, downwardly-oriented displacement of the die (20) relative to the bonding head (12) and lateral return movement (100, 101) of the bonding head (12) and/or lateral advance movement (102) of the support surface, breaking the wire (22) (Fig. 9), and
g) raising the bonding head (12) back into the initial or outset position.

18. Method of bonding wire, particularly with a device according to claims 1 to 16, wherein the cutter (30) or the like wire-separating member, seen in the wire feed direction, lies behind the die (20), and including the following method of operation:
a) lowering the bonding head (12) from an upper start or outset position, carrying along with it a wire (22), to a first contact surface (14) at bonding height,
b) touch-down of the die (20) disposed on the bonding head (12), with ultrasound energisation of said die and formation of a first bond (76) (Fig. 4),
c) moving the bonding head (12) along a predetermined three-dimensional curve (78), forming a wire loop (80), to a second contact surface (16) (Fig. 5),
d) touch-down of the die (20) disposed on the bonding head (12), with ultrasound energisation of said die and formation of a second bond (84) (Fig. 5),
e) raising (86) and lateral return movement (88) of the bonding head (12), forming a so-called tail length (92) (Fig. 6),
f) renewed lowering (90) of the bonding head (12) on to wire (22) with linear, upwardly-oriented (z-axis) displacement (92) of the die (20) relative to the bonding head (12), and with partial separation of the wire (22) by the cutter (30) disposed at the bonding head (12) (Fig. 7),
g) raising (94) the bonding head (12) to a wire-breaking height, releasing the cutter (30) and with linear, downwardly-oriented displacement (96) of the die (20) relative to the bonding head (12), and with lateral return movement (100, 101) of the bonding head (12) and/or lateral advance movement (102) of the support surface, breaking off the wire (22) (Fig. 9), and
h) raising the bonding head (12) back the initial or outset position.

## Revendications

1. Dispositif pour la connexion d'un fil et comportant un poinçon (wedge 20) repoussant le fil (22) contre une surface de contact (14,16) et pouvant être excité par ultrasons et qui est disposé, à cet effet, sur une tête de connexion (12) pouvant être soulevée et abaissée (axe z) perpendiculairement à la surface de contact (14,16), la surface de contact (14,16) étant située sur un support (18), qui est déplaçable dans une direction approximativement transversale par rapport à la direction de déplacement (axe z) de la tête de connexion (2), moyennant le positionnement de la surface de contact (14,16) par rapport au poinçon (20), et comportant un dispositif pour commander un dispositif d'entraînement pour la tête de connexion (12), le poinçon (20) étant monté de manière à être déplaçable sur la tête de connexion (12),
caractérisé en ce que le poinçon (20) est fixé à un chariot de guidage (24), qui est monté de manière à être déplaçable linéairement contre la tête de connexion (12), parallèlement à la direction de déplacement (axe z) de la tête de connexion.

2. Dispositif selon la revendication 1, caractérisé en ce que le chariot de guidage (24) est retenu de manière à être déplaçable, par l'intermédiaire d'un guide linéaire de précision (26), notamment d'un guide linéaire supporté par des billes ou des galets ou à suspension pneumatique.

3. Dispositif selon l'une des revendications 1 ou 2, caractérisé en ce que la tête de connexion (12) comprend un capteur (28) qui est associé au poinçon (20) pour déterminer ce qu'on appelle la hauteur touch-down et qui est accouplé au dispositif d'entraînement prévu pour la tête de connexion (12).

4. Dispositif selon l'une des revendications 1 à 3, caractérisé en ce qu'au poinçon (20) est associé un couteau (30) ou un élément de séparation analogue, qui sert à sectionner, notamment partiellement, le fil (22), le couteau (30) étant monté fixe sur la tête de connexion (12), c'est-à-dire qu'il peut être entraîné conjointement avec cette dernière.

5. Dispositif selon la revendication 4, caractérisé en ce que le couteau (30) est fixé sur la tête de connexion (12), de manière à être réglable dans sa direction de déplacement (axe z).

6. Dispositif selon la revendication 4 et/ou 5, caractérisé en ce que le couteau (30) est fixé sur la tête de connexion (12) de manière à être réglable dans une direction (axe x) perpendiculaire à sa direction de déplacement (axe z), notamment de telle sorte que le couteau (30) peut être amené dans une position située en avant ou en arrière du poinçon (20), lorsqu'on regarde dans la direction d'amenée du fil.

7. Dispositif selon l'une des revendications 4 à 6, caractérisé en ce qu'au couteau (30) est associé un capteur (42) servant à régler la course maximale du couteau.

8. Dispositif selon l'une des revendications 1 à 7, caractérisé en ce qu'entre la tête de connexion (12) et le chariot de guidage (24) pour le poinçon (20) est installé un dispositif (44) servant à régler le "poids", qui charge le fil (22).

9. Dispositif selon la revendication 8, caractérisé en ce que le dispositif (44) de réglage du poids comprend un dispositif (46,48,50) de production d'un champ magnétique, au moyen duquel il est possible de régler un flux de force, qui s'étend approximativement parallèlement à la direction de déplacement (axe z) de la tête de connexion (12), entre la tête de connexion (12) et le chariot de guidage (24).

10. Dispositif selon la revendication 8 et/ou 9, caractérisé en ce qu'entre la tête de connexion (12) et le chariot de guidage (24) est prévu un dispositif d'application de force (52) servant à appliquer une force, qui agit à l'encontre de la force du dispositif (44) de réglage du poids et parallèlement à la direction de déplacement (axe z) de la tête de connexion (12).

11. Dispositif selon la revendication 10, caractérisé en ce qu'un élément de ressort réglable (62) est disposé entre la tête de connexion (12) et le chariot de guidage (24).

12. Dispositif selon la revendication 11, caractérisé en ce qu'il est prévu comme élément de ressort (62) un ressort hélicoïdal.

13. Dispositif selon l'une des revendications 10 à 12, caractérisé en ce qu'au dispositif d'application de force (52) est associé un micro-interrupteur (66) servant à limiter le déplacement relatif entre la tête de connexion (12) et le chariot de guidage (24).

14. Dispositif selon l'une des revendications 1 à 13, caractérisé en ce qu'au poinçon (20) est associé un petit tube de guidage (36) pour le fil (22), qui est fixé au chariot de guidage (24).

15. Dispositif selon la revendication 14, caractérisé en ce qu'au petit tube de guidage (36) est associée une douille de guidage (38) en forme de capillaire, qui est articulée, selon une connexion élastique telle que celle fournie par un ressort, notamment sur le petit tube de guidage (36), et qui sert à orienter le fil (22) en direction de l'extrémité inférieure libre du poinçon (20).

16. Dispositif selon l'une des revendications 1 à 15, caractérisé en ce que la tête de connexion (12) comporte un cadre rotatif (70) servant à déplacer la tête de connexion (12) et par conséquent le poinçon (20), etc. dans un plan (axe x, axe y) parallèle au support.

17. Procédé pour la connexion d'un fil, notamment à l'aide d'un dispositif selon l'une des revendications 1 à 16, selon lequel le couteau (30) ou un élément analogue de sectionnement du fil est situé, lorsqu'on regarde dans la direction d'amenée du fil, en avant du poinçon (20), ce procédé comprenant l'exécution des étapes opératoires suivantes :
a) abaissement de la tête de connexion (12) depuis une position de départ ou position initiale supérieure, tout en entraînant un fil (22) jusqu'à une première surface de contact (14), à la hauteur de connexion,
b) déplacement "touch-down" (c'est-à-dire abaissement et établissement d'un contact) du poinçon (20) disposé sur la tête de connexion (12), moyennant une excitation par ultrasons du poinçon et la formation d'une première connexion (76) (figure 4),
c) déplacement de la tête de connexion (12) le long d'une courbe spatiale prédéterminée (78) avec formation d'une boucle de fil (80) jusqu'à une seconde surface de contact (16) (figure 5),
d) déplacement "touch-down" du poinçon (20) disposé sur la tête de connexion (12) moyennant une excitation par ultrasons de ce poinçon et formation d'une seconde connexion (84) (figure 5),
e) abaissement ultérieur (130) de la tête de connexion (12) moyennant un déplacement linéaire ascendant (axe z) du poinçon (20) par rapport à la tête de connexion (12) et moyennant un sectionnement partiel du fil (22) par le couteau (30) disposé sur la tête de connexion (12) (figure 10),
f) soulèvement (94) de la tête de connexion (12) avec libération du couteau (30) et moyennant un déplacement linéaire descendant du poinçon (20) par rapport à la tête de connexion (12) et recul latéral (100, 101) de la tête de connexion (12) et/ou avance latérale (102) du support, moyennant l'arrachement du fil (22) (figure 9), et
g) soulèvement de la tête de connexion (12) avec retour dans la position de départ ou position initiale.

18. Procédé pour établir la connexion d'un fil, notamment à l'aide d'un dispositif selon les revendications 1 à 16, selon lequel le couteau (30) ou un élément analogue de sectionnement du fil est situé en arrière du poinçon (20) lorsqu'on regarde dans la direction d'amenée du fil, et qui inclut les modes opératoires suivants :
a) abaissement de la tête de connexion (12) depuis une position de départ ou position initiale supérieure, tout en entraînant un fil (22) jusqu'à une première surface de contact (14), à la hauteur de connexion,
b) déplacement "touch-down" (c'est-à-dire abaissement et établissement d'un contact) du poinçon (20) disposé sur la tête de connexion (12), moyennant une excitation par ultrasons du poinçon et la formation d'une première connexion (76) (figure 4),
c) déplacement de la tête de connexion (12) le long d'une courbe spatiale prédéterminée (78) avec formation d'une boucle de fil (80) jusqu'à une seconde surface de contact (16) (figure 5),
d) déplacement "touch-down" du poinçon (20) disposé sur la tête de connexion (12) moyennant une excitation par ultrasons de ce poinçon et formation d'une seconde connexion (84) (figure 5),
e) soulèvement (86) et recul latéral (88) de la tête de connexion (12) et/ou avance latérale du support moyennant la formation de ce qu'on appelle une "tail-length" (92) (figure 6),
f) nouvel abaissement (90) de la tête de connexion (12) sur le fil (22) moyennant un déplacement linéaire ascendant (axe z) (92) du poinçon (20) par rapport à la tête de connexion (12) et moyennant le sectionnement partiel du fil (22) par le couteau (30) disposé sur la tête de connexion (12) (figure 7),
g) soulèvement (94) de la tête de connexion (12) jusqu'à une hauteur d'arrachement du fil, moyennant la libération du couteau (30) et moyennant un déplacement linéaire descendant (96) du poinçon (20) par rapport à la tête de connexion (12) et recul latéral (100,101) de la tête de connexion (12) et/ou avance latérale (102) du support moyennant un arrachement du fil (22) (figure 9), et
h) soulèvement de la tête de connexion (12) avec retour de cette dernière dans la position de départ ou position initiale.
